# EUROPEAN PATENT SPECIFICATION

(11) **EP 4 241 986 B1**
(45) Date of publication and mention of the grant of the patent: **03.12.2025**
(21) Application number: 21888957.4
(22) Date of filing: 04.10.2021
(51) Int. Cl.: B32B 27/20, B32B 7/022, B32B 7/027, B32B 27/08, B32B 27/30, H01L 23/373, H01L 23/42

(54) **HEAT CONDUCTIVE MEMBER**
WÄRMELEITENDES ELEMENT
ÉLÉMENT THERMOCONDUCTEUR

(30) Priority: 06.11.2020 JP 2020185938
(43) Date of publication of application: 13.09.2023
(73) Proprietor: Kitagawa Industries Co., Ltd., Inazawa-shi, Aichi 492-8446 (JP)
(72) Inventor: TACHI, Naohiro, Kasugai-shi, Aichi 480-0303 (JP)
(74) Representative: Cabinet Bleger-Rhein-Poupon
(86) International application number: PCT/JP2021/036675
(87) International publication number: WO 2022/097404

(56) References cited:
- JP-A- 2008 111 053
- JP-A- 2011 054 609
- JP-A- 2012 069 425
- JP-A- 2019 015 885
- JP-B2- 6 710 828
- US-A1- 2011 135 911
- US-A1- 2017 291 391
- US-A1- 2019 217 582

## Description

### Technical Field

The present disclosure relates to a thermally conductive member.

### Background Art

A thermally conductive sheet including a low-hardness layer and a reinforcing layer stacked on one side or both sides of the low-hardness layer has been known (refer to, for example, Patent Literature 1). In the thermally conductive sheet disclosed in Patent Literature 1, the low-hardness layer contains an acrylic polymer, silicon carbide, aluminum hydroxide, magnesium hydroxide, and a plasticizer. Patent Literature 2 discloses also a thermally conductive laminate comprising a low-hardness layer and a reinforcing layer. Patent Literature 3 and Patent Literature 4 disclose sheets with thermal conductivity for bonding a heat conductor and an electrically conductive layer, comprising a polymer, an epoxy resin, a magnesium carbonate and another inorganic filler, such as alumina, silica or silicon carbide, among others.

### Citation List

### Patent Literature

Patent Literature 1: JP No. 6710828 B
Patent Literature 2: US 2017/291391 A1
Patent Literature 3: US 2011/135911 A1
Patent Literature 4: JP 2012 069425 A

### Summary of Invention

### Technical Problem

In general, in the thermally conductive sheet as described above, the thermal conductivity of the thermally conductive sheet can be increased by increasing a blending ratio of a thermally conductive filler in the low-hardness layer. However, when the blending ratio of the thermally conductive filler is increased, the low-hardness layer tends to become hard. Therefore, the flexibility of the thermally conductive sheet is decreased, and the thermally conductive sheet is less likely to be deformed. For example, when a thermally conductive sheet is sandwiched between an electronic component serving as a heat source and a heat sink, the thermally conductive sheet is less likely to be deformed even if the thermally conductive sheet is compressed. As a result, a contact pressure to the electronic component is increased, and a load due to the increase of the contact pressure is easily applied to the electronic component.

On the other hand, when the blending ratio of the plasticizer in the low-hardness layer is increased, the hardness of the low-hardness layer can be decreased. However, when the blending ratio of the plasticizer is increased, the adhesiveness of the low-hardness layer tends to be increased. For this reason, at the time of producing the thermally conductive sheet, the productivity is reduced, for example, it becomes difficult to perform a cutting process. In addition, when the thermally conductive sheet is used, the workability is reduced, for example, cut portions adhere to each other and it is difficult to peel off the cut portions. Further, when the blending ratio of the plasticizer is increased, oil bleeding may occur. Therefore, there is a problem in that it is difficult to improve both the thermal conductivity and the hardness of the thermally conductive sheet.

In one aspect of the present disclosure, it is desirable to provide a thermally conductive member having both high thermal conductivity and low hardness.

### Solution to Problem

A thermally conductive member according to an aspect of the present disclosure is a laminate provided with a plurality of layers including a first layer and a second layer stacked in contact with each other. The first layer is formed of a first thermally conductive composition containing at least a first acrylic binder, a first thermally conductive filler, and a dispersant. The second layer is formed of a second thermally conductive composition containing at least a second acrylic binder and a second thermally conductive filler. In the first thermally conductive composition, from 500 to 1200 parts by mass of the first thermally conductive filler and from 0.2 to 5 parts by mass of the dispersant are blended in mass ratios relative to 100 parts by mass of the first acrylic binder. In the second thermally conductive composition, from 200 to 400 parts by mass of the second thermally conductive filler is blended in a blending ratio relative to 100 parts by mass of the second acrylic binder. The dispersant contains at least one of a linear polyester having a weight-average molecular weight from 1000 to 2500 and having phosphoric acid at a terminal and a polyester-polyether copolymer having a weight-average molecular weight from 1000 to 2500 and having phosphoric acid at a terminal.

According to the thermally conductive member configured as described above, the thermally conductive member has both high thermal conductivity and low hardness as compared with a known product. In addition, adhesiveness of the first layer can be suppressed and the occurrence of oil bleeding in the first layer can be suppressed as compared with known products.

### Brief Description of Drawings

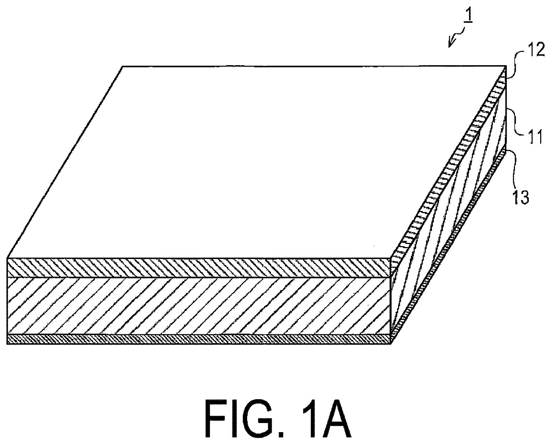

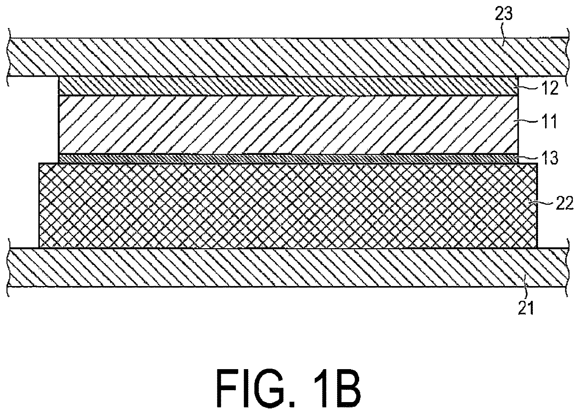

FIG. 1A is a schematic perspective view of a thermally conductive member. FIG. 1B is an explanatory view illustrating a state of use of the thermally conductive member.

### Reference Signs List

1... Thermally conductive member, 11... First layer, 12... Second layer, 13... Third layer, 21... Electronic circuit board, 22... Electronic component, 23... Metal panel

### Description of Embodiments

Next, the thermally conductive member described above will be explained using an exemplary embodiment.

### (1) Configuration of thermally conductive member

As illustrated in FIG. 1A, a thermally conductive member 1 is a laminate provided with a plurality of layers including a first layer 11, a second layer 12, and a third layer 13. The first layer 11 and the second layer 12 are stacked in contact with each other. The third layer 13 is stacked at a position in contact with the first layer 11 on the side opposite to the second layer 12 with the first layer 11 interposed therebetween.

The first layer 11 is formed of a first thermally conductive composition. The first thermally conductive composition contains at least a first acrylic binder, a first thermally conductive filler, and a dispersant. The blending amount of the first thermally conductive filler is set to from 500 to 1200 parts by mass and more preferably from 600 to 1000 parts by mass in terms of a mass ratio relative to 100 parts by mass of the first acrylic binder.

When the blending ratio of the first thermally conductive filler is 500 parts by mass or greater, the first layer 11 can be a layer having excellent thermal conductivity as compared with a case where the blending ratio of the first thermally conductive filler is less than 500 parts by mass. When the blending ratio of the first thermally conductive filler is 600 parts by mass or greater, the first layer 11 can be a layer that is further excellent in the thermal conductivity. On the other hand, when the blending ratio of the first thermally conductive filler is 1,200 parts by mass or less, it is possible to suppress the hardness of the first layer 11 from becoming excessively high as compared to a case where the blending ratio of the first thermally conductive filler is greater than 1200 parts by mass. When the blending ratio of the first thermally conductive filler is 1000 parts by mass or less, the hardness of the first layer 11 can be further reduced.

In the present embodiment, the first acrylic binder contains at least an acrylic polymer and a plasticizer. The blending amount of the plasticizer is 15 to 45 parts by mass in terms of a mass ratio relative to 100 parts by mass of the acrylic polymer. When the blending ratio of the plasticizer is 15 parts by mass or greater, the hardness of the first layer 11 can be reduced as compared to a case where the blending ratio of the plasticizer is less than 15 parts by mass. When the blending ratio of the plasticizer is 45 parts by mass or less, it is possible to suppress the occurrence of excessive adhesiveness in the first layer 11 and to suppress oil bleeding from the first layer 11, as compared to a case where the blending ratio of the plasticizer is greater than 45 parts by mass.

As the acrylic polymer, for example, an acrylic polymer obtained by polymerizing or copolymerizing an acrylic resin containing a polymer obtained by polymerizing a monomer containing a (meth)acrylic acid ester and a (meth)acrylic acid ester can be used.

Examples of the (meth)acrylic acid ester include ethyl (meth)acrylate, n-propyl (meth)acrylate, i-propyl (meth)acrylate, n-butyl (meth)acrylate, i-butyl (meth)acrylate, 2-ethyl hexyl (meta) acrylate, n-hexyl (meth)acrylate, n-amyl (meth)acrylate, i-amyl (meth)acrylate, octyl (meth)acrylate, i-octyl (meth)acrylate, i-myristyl (meth)acrylate, lauryl (meth)acrylate, nonyl (meth)acrylate, i-nonyl (meth)acrylate, i-decyl (meth)acrylate, tridecyl (meth)acrylate, stearyl (meth)acrylate, and i-stearyl (meth)acrylate. These may be used alone or in combination for (co)polymerization.

An acrylic polymer can be obtained by adding an additive such as a multifunctional monomer, a polymerization initiator, and a plasticizer, to the above described acrylic resin as appropriate, followed by heating and curing.

Examples of the multifunctional monomer include a multifunctional monomer having two or more (meth)acryloyl groups in a molecule. Examples of the di-functional (meth)acrylate monomer having two (meth)acryloyl groups include 1,3-butylene glycol di(meth)acrylate, 1,4-butanediol di(meth)acrylate, 1,6-hexanediol di(meth)acrylate, 1,9-nonanediol di(meth)acrylate, neopentyl glycol di(meth)acrylate, dicyclopentanyl di(meth)acrylate, 2-ethyl-2-butyl-propanediol (meth)acrylate, neopentylglycol-modified trimethylolpropane di(meth)acrylate, stearic acid-modified pentaerythritol diacrylate, polypropylene glycol di(meth)acrylate, 2,2-bis[4-(meth)acryloxydiethoxyphenyl]propane, 2,2-bis[4-(meth)acryloxypropoxyphenyl]propane, and 2,2-bis[4-(meth)acryloxytetraethoxyphenyl]propane.

Examples of the tri-functional (meth)acrylate monomer include trimethylolpropane tri(meth)acrylate and tris[(meth)acryloxyethyl]isocyanurate. Examples of the multifunctional (meth)arylate monomer having 4 or more functional groups include dimethylolpropane tetra(meth)arylate, pentaerythritol tetra(meth)acrylate, pentaerythritol ethoxytetra(meth)acrylate, dipentaerythritol penta(meth)acrylate, and dipentaerythritol hexa(meth)acrylate.

Among these multifunctional monomers, 1,6-hexanediol di(meth)acrylate and the like are preferred.

The multifunctional monomer described above is preferably blended in an amount of 0.005 to 0.015 parts by mass in the first layer 11 relative to 20 to 25 parts by mass of the acrylic resin.

Examples of the polymerization initiator include organic peroxides such as di-(4-t-butylcyclohexyl)peroxydicarbonate, lauroyl peroxide, t-amylperoxy-2-ethylhexanoate, benzoyl peroxide, and t-butylperoxy-2-ethylhexanoate. Among these polymerization initiators, di-(4-t-butylcyclohexyl)peroxydicarbonate is preferred.

The polymerization initiator is preferably blended in an amount from 0.1 to 0.3 parts by mass relative to 20 to 25 parts by mass of the acrylic resin.

For a plasticizer, a generally used plasticizer can be used. For example, a phthalate-based plasticizer, an adipate-based plasticizer, a phosphate-based plasticizer, a trimellitate-based plasticizer, or a polyester-based plasticizer can be used suitably. Any one kind of these plasticizers can be used alone or two or more kinds of these plasticizers can be used as a mixture. With the plasticizer blended, the first layer 11 has a low hardness, and the flexibility is imparted to the thermally conductive member 1.

An antioxidant may be added to the first layer 11 as an additive. Examples of the antioxidant include a phenol-based antioxidant that has radical complementary action. Blending such an antioxidant can suppress polymerization of the acrylic resin during sheet production and thus reduce the hardness of the sheet to a lower level.

The antioxidant is preferably blended in an amount from 0.05 to 0.10 parts by mass relative to 20 to 25 parts by mass of the acrylic resin. If the blending amount of the antioxidant is too small, polymerization of the acrylic resin may proceed excessively so that the hardness of the sheet becomes too large. If the blending amount of the antioxidant is too large, curing of the resin may be hindered.

In the case of the present embodiment, the first thermally conductive filler contains at least silicon carbide having an average particle diameter from 60 to 100 µm, first spherical alumina having an average particle diameter from 70 to 100 µm, second spherical alumina having an average particle diameter from 1 to 30 µm, and first magnesium hydroxide having an average particle diameter from 0.5 to 2 µm. The average particle diameter referred to in the present disclosure is an average particle diameter D50 determined by a laser diffractometry or the like.

When the average particle diameter of silicon carbide is 60 µm or greater, the bonding strength between the first layer 11 and the second layer 12 can be improved as compared with a case where the average particle diameter of silicon carbide is less than 60 µm. In addition, when the average particle diameter of silicon carbide is 100 µm or less, it is possible to suppress the particles of silicon carbide from falling off from the thermally conductive member 1 in the production of the thermally conductive member 1, as compared with a case where the average particle diameter of silicon carbide is greater than 100 µm.

The first spherical alumina and the second spherical alumina are two kinds of spherical alumina having different average particle diameters. When such two kinds of spherical alumina are blended, spherical alumina having a small average particle diameter is filled between particles of silicon carbide and between particles of spherical alumina having a large average particle diameter. As a result, the number of contact portions between the particles constituting the thermally conductive filler can be increased, and the thermal conductivity of the first layer 11 can be improved.

When the average particle diameter of the first spherical alumina is 70 µm or greater and the average particle diameter of the second spherical alumina is 30 µm or less, the difference in particle diameter between the first spherical alumina and the second spherical alumina becomes sufficiently large. As compared with a case where the difference in particle diameter is small, the effect becomes remarkable by blending spherical alumina having different average particle diameters. In addition, when the average particle diameter of the first spherical alumina is 100 µm or less, it is possible to suppress the particles of the first spherical alumina from falling off from the thermally conductive member 1 in the production of the thermally conductive member 1, as compared with a case where the average particle diameter of the first spherical alumina is greater than 100 µm. When the average particle diameter of the second spherical alumina is 1 µm or greater, it is possible to suppress the viscosity of the first thermally conductive filler from excessively increasing as compared with a case where the average particle diameter of the second spherical alumina is less than 1 µm.

Both the first spherical alumina and the second spherical alumina are low-soda alumina. The low-soda alumina referred to in the present embodiment is alumina in which a Na content contained as an impurity is suppressed to 0.1 mass% or less in terms of Na2O.

When the average particle diameter of the first magnesium hydroxide is from 0.5 to 2 µm, the viscosity of the first thermally conductive filler can be appropriately increased.

The dispersant contains at least one of a linear polyester having a weight-average molecular weight from 1000 to 2500 and having phosphoric acid at a terminal and a polyester-polyether copolymer having a weight-average molecular weight from 1000 to 2500 and having phosphoric acid at a terminal. By blending such a dispersant, the dispersibility of the first thermally conductive filler in the first acrylic binder can be improved. Therefore, the thermal conductivity of the first layer 11 can be improved as compared with a case where a similar dispersant is not blended. The blending amount of the dispersant is from 0.2 to 5 parts by mass and more preferably from 0.2 to 2.0 parts by mass in terms of a mass ratio relative to 100 parts by mass of the acrylic polymer.

In the case of the present embodiment, the first layer 11 configured as described above is configured to have an Asker C hardness from 0.1 to 22. This allows the first layer 11 to have a sufficiently low hardness. In the case of the present embodiment, the first layer 11 is configured to have a thermal conductivity from 2 to 15 W/m·K. This allows the first layer 11 to have a sufficiently high thermal conductivity.

The second layer 12 is formed of a second thermally conductive composition containing at least a second acrylic binder and a second thermally conductive filler. In the second thermally conductive composition, 200 to 400 parts by mass (more preferably from 250 to 350 parts by mass) of the second thermally conductive filler is blended in a blending ratio relative to 100 parts by mass of the second acrylic binder.

In the present embodiment, the second acrylic binder contains at least an acrylic polymer. As the acrylic polymer, an acrylic polymer similar to the acrylic polymer contained in the first acrylic binder can be used. However, the second layer 12 has a higher hardness than the first layer 11. Therefore, for example, the blending amount of the multifunctional monomer may be larger than that of the first layer 11, and for example, it is preferable to blend 0.05 to 0.10 parts by mass of the multifunctional monomer in the second layer 12.

In the case of the present embodiment, 90 to 100 parts by mass of aluminum hydroxide as an essential component and 0 to 10 parts by mass of the second magnesium hydroxide as an optional component are blended in the second thermally conductive filler at a mass ratio in 100 parts by mass of the second thermally conductive filler. That is, 100 parts by mass of the second thermally conductive filler may be formed of 100 parts by mass of aluminum hydroxide as an essential component, or may be formed such that the second magnesium hydroxide as an optional component is blended in a range of 10 parts by mass or less with respect to aluminum hydroxide as an essential component and the total of aluminum hydroxide and the second magnesium hydroxide is 100 parts by mass.

The second layer 12 configured as described above is a layer having a higher hardness than the first layer 11 and a lower adhesiveness than the first layer 11. Therefore, when one surface of the first layer 11 is covered with the second layer 12, it is possible to suppress the occurrence of adhesiveness on one surface of the thermally conductive member 1 as compared with a thermally conductive member in which the second layer 12 is not provided.

The third layer 13 is formed of a resin film having a thickness of 1 to 15 µm. The resin constituting the resin film may be any resin as long as the resin does not excessively inhibit the thermal conduction performance of the thermally conductive member 1. An example of the resin is a polyester film such as a PET film. PET is an abbreviation for polyethylene terephthalate.

The third layer 13 is a layer having a higher hardness than the first layer 11 and a lower adhesiveness than the first layer 11. Therefore, when one surface of the first layer 11 is covered with the third layer 13, it is possible to suppress the occurrence of adhesiveness on one surface of the thermally conductive member 1 as compared with a thermally conductive member in which the third layer 13 is not provided.

As illustrated in FIG. 1B, for example, the thermally conductive member 1 configured as described above is interposed between an electronic component 22 mounted on one surface of an electronic circuit board 21 and a metal panel 23 constituting a housing of an electronic device. Thus, heat generated in the electronic component 22 is conducted to the metal panel 23 via the thermally conductive member 1, and heat discharge from the electronic component 22 can be promoted. Although the second layer 12 is in contact with the metal panel 23 and the third layer 13 is in contact with the electronic component 22 in the example illustrated in FIG. 1B, the second layer 12 may be in contact with the electronic component 22 and the third layer 13 may be in contact with the metal panel 23.

The thickness of the first layer 11 is preferably about from 0.7 to 5.9 mm. The thickness of the second layer 12 is preferably about from 0.1 to 0.3 mm. By configuring the thicknesses of the first layer 11 and the second layer 12 to be equal to or greater than the above-described lower limit value, it is possible to suppress the thermally conductive member 1 from being torn when an external force acts on the thermally conductive member 1. In addition, by configuring the thicknesses of the first layer 11 and the second layer 12 to be equal to or less than the above-described upper limit value, it is possible to exhibit good thermal conductivity.

### (2) Production example of thermally conductive member

Next, a method for producing the thermally conductive member will be described.

### (2.1) Production example of first layer

### Example 1

A first thermally conductive filler was prepared by mixing 29.14 parts by mass of silicon carbide having an average particle diameter from 60 to 100 µm, 34.30 parts by mass of first spherical alumina having an average particle diameter from 70 to 100 µm, 32.65 parts by mass of second spherical alumina having an average particle diameter from 1 to 30 µm, and 3.91 parts by mass of first magnesium hydroxide having an average particle diameter from 0.5 to 2 µm.

Subsequently, 671.58 parts by mass of the first thermally conductive filler and 0.62 parts by mass of a dispersant were blended with 100 parts by mass of the first acrylic binder to prepare a first thermally conductive composition. As the first acrylic binder, a composition in which 22.52 parts by mass of a plasticizer was blended with 100 parts by mass of an acrylic polymer was used.

The first thermally conductive composition was molded into a sheet shape to obtain a molded article corresponding to the first layer 11. When the Asker C hardness and the thermal conductivity were measured, the Asker C hardness was 3, and the thermal conductivity was 2.369 W/m·K.

### Example 2

852.81 parts by mass of the first thermally conductive filler as in the first embodiment and 0.57 parts by mass of a dispersant were blended with 100 parts by mass of the first acrylic binder to prepare a first thermally conductive composition. As the first acrylic binder, a composition in which 22.40 parts by mass of a plasticizer was blended with 100 parts by mass of an acrylic polymer was used.

The first thermally conductive composition was molded into a sheet shape to obtain a molded article corresponding to the first layer 11. When the Asker C hardness and the thermal conductivity were measured, the Asker C hardness was 7, and the thermal conductivity was 3.372 W/m·K.

### Example 3

948.58 parts by mass of the first thermally conductive filler as in the first embodiment and 0.63 parts by mass of a dispersant were blended with 100 parts by mass of the first acrylic binder to prepare a first thermally conductive composition. As the first acrylic binder, a composition in which 22.49 parts by mass of a plasticizer was blended with 100 parts by mass of an acrylic polymer was used.

The first thermally conductive composition was molded into a sheet shape to obtain a molded article corresponding to the first layer 11. When the Asker C hardness and the thermal conductivity were measured, the Asker C hardness was 7, and the thermal conductivity was 3.899 W/m·K.

### Comparative Example 1

1302.10 parts by mass of the first thermally conductive filler as in the first embodiment and 0.56 parts by mass of a dispersant were blended with 100 parts by mass of the first acrylic binder to prepare a first thermally conductive composition. As the first acrylic binder, a composition in which 22.51 parts by mass of a plasticizer was blended with 100 parts by mass of an acrylic polymer was used.

The first thermally conductive composition was molded into a sheet shape to obtain a molded article corresponding to the first layer 11. When the Asker C hardness and the thermal conductivity were measured, the Asker C hardness was 29, and the thermal conductivity was 5.124 W/m-K. By setting the blending ratio of the first thermally conductive filler to 1302.10 parts by mass, the Asker C hardness was 29.

### Comparative Example 2

853.29 parts by mass of the first thermally conductive filler as in the first embodiment was blended with 100 parts by mass of the first acrylic binder to prepare a first thermally conductive composition. As the first acrylic binder, a composition in which 22.40 parts by mass of a plasticizer was blended with 100 parts by mass of an acrylic polymer was used.

The first thermally conductive composition was molded into a sheet shape to obtain a molded article corresponding to the first layer 11. When the Asker C hardness was measured, the Asker C hardness was 29. Although the blending amount of the first thermally conductive filler was close to that in Example 2, the dispersant was not blended, and thus the Asker C hardness was 29.

### Comparative Example 3

853.29 parts by mass of the first thermally conductive filler as in the first embodiment was blended with 100 parts by mass of the first acrylic binder to prepare a first thermally conductive composition. As the first acrylic binder, a composition in which 38.94 parts by mass of a plasticizer was blended with 100 parts by mass of an acrylic polymer was used.

The first thermally conductive composition was molded into a sheet shape to obtain a molded article corresponding to the first layer 11. When the Asker C hardness was measured, the Asker C hardness was 24. Although the blending amount of the first thermally conductive filler was close to that in Example 2, and the blending amount of the plasticizer was also increased as compared with Comparative Example 2, the dispersant was not blended, and thus the Asker C hardness was 24.

### Comparative Example 4

853.10 parts by mass of the first thermally conductive filler as in the first embodiment and 0.19 parts by mass of a dispersant were blended with 100 parts by mass of the first acrylic binder to prepare a first thermally conductive composition. As the first acrylic binder, similar to Comparative Example 3, a composition in which 38.94 parts by mass of a plasticizer was blended with 100 parts by mass of an acrylic polymer was used.

The first thermally conductive composition was molded into a sheet shape to obtain a molded article corresponding to the first layer 11. When the Asker C hardness was measured, the Asker C hardness was 23. Although the blending amount of the first thermally conductive filler was close to that in Example 2, and the blending amount of the plasticizer was the same as that in Comparative Example 3 and larger than that in Example 2, the blending amount of the dispersant was as small as 0.19 parts by mass, so that the Asker C hardness was 23.

### Example 4

853.00 parts by mass of the first thermally conductive filler as in the first embodiment and 0.29 parts by mass of a dispersant were blended with 100 parts by mass of the first acrylic binder to prepare a first thermally conductive composition. As the first acrylic binder, a composition in which 38.94 parts by mass of a plasticizer was blended with 100 parts by mass of an acrylic polymer was used.

The first thermally conductive composition was molded into a sheet shape to obtain a molded article corresponding to the first layer 11. When the Asker C hardness was measured, the Asker C hardness was 20. Although the blending amount of the first thermally conductive filler and the blending amount of the plasticizer were almost the same as that in Comparative Example 4, the blending amount of the dispersant was 0.29 parts by mass, so that the Asker C hardness was 20.

### Example 5

852.72 parts by mass of the first thermally conductive filler as in the first embodiment and 0.57 parts by mass of a dispersant were blended with 100 parts by mass of the first acrylic binder to prepare a first thermally conductive composition. As the first acrylic binder, a composition in which 38.94 parts by mass of a plasticizer was blended with 100 parts by mass of an acrylic polymer was used.

The first thermally conductive composition was molded into a sheet shape to obtain a molded article corresponding to the first layer 11. When the Asker C hardness and the thermal conductivity were measured, the Asker C hardness was 7, and the thermal conductivity was 3.354 W/m K.

### (2.2) Production example of second layer

### Example 6

Aluminum hydroxide having an average particle diameter from 5 to 50 µm was used as a second thermally conductive filler, and 281.10 parts by mass of the second thermally conductive filler was mixed with 100 parts by mass of the second acrylic binder to prepare a second thermally conductive composition. As the second acrylic binder, an acrylic polymer was used.

The second thermally conductive composition was molded into a sheet shape to obtain a molded article corresponding to the second layer 12. When the Asker C hardness and the thermal conductivity were measured, the Asker C hardness was 45, and the thermal conductivity was 1.04 W/m·K.

### Example 7

A second thermally conductive filler was prepared by mixing 263.67 parts by weight of aluminum hydroxide having an average particle diameter from 5 to 50 µm and 17.14 parts by weight of a second magnesium hydroxide having an average particle diameter from 0.5 to 2 µm. 280.81 parts by mass of the second thermally conductive filler was blended with 100 parts by mass of the second acrylic binder to prepare a second thermally conductive composition. As the second acrylic binder, an acrylic polymer was used.

The second thermally conductive composition was applied to the first layer 11 to obtain a molded article corresponding to the second layer 12.

### Example 8

Aluminum hydroxide having an average particle diameter from 5 to 50 µm was used as a second thermally conductive filler, and 337.25 parts by mass of the second thermally conductive filler was mixed with 100 parts by mass of the second acrylic binder to prepare a second thermally conductive composition. As the second acrylic binder, an acrylic polymer was used.

The second thermally conductive composition was applied to the first layer 11 to obtain a molded article corresponding to the second layer 12. When the Asker C hardness and the thermal conductivity were measured, the Asker C hardness was 64, and the thermal conductivity was 1.28 W/m·K.

### Comparative Example 5

Aluminum hydroxide having an average particle diameter from 5 to 50 µm was used as a second thermally conductive filler, and 421.65 parts by mass of the second thermally conductive filler was mixed with 100 parts by mass of the second acrylic binder to prepare a second thermally conductive composition. As the second acrylic binder, an acrylic polymer was used.

The second thermally conductive composition was applied to the first layer 11 to obtain a molded article corresponding to the second layer 12. When the Asker C hardness and the thermal conductivity were measured, the Asker C hardness was 77, and the thermal conductivity was 1.55 W/m·K. Since the blending amount of the second thermally conductive filler was excessive, the properties of the second thermally conductive composition became rough, and the composition had poor coatability.

### Comparative Example 6

Aluminum hydroxide having an average particle diameter from 5 to 50 µm was used as a second thermally conductive filler, and 137.19 parts by mass of the second thermally conductive filler was mixed with 100 parts by mass of the second acrylic binder to prepare a second thermally conductive composition. As the second acrylic binder, an acrylic polymer was used.

The second thermally conductive composition was applied to the first layer 11 to obtain a molded article corresponding to the second layer 12. When the Asker C hardness and the thermal conductivity were measured, the Asker C hardness was 9, and the thermal conductivity was 0.58 W/m-K. Since the blending amount of the second thermally conductive filler was excessively small, the properties of the second thermally conductive composition became fragile, and the composition had poor coatability.

### (3) Other Embodiments

Although an exemplary embodiment has been used to describe the thermally conductive member 1, the present embodiment should not be construed to be any more than an example of one form of the present disclosure. That is, the present disclosure is not limited to the exemplary embodiments described above, and can be carried out in various forms without departing from the technical concept of the present disclosure.

For example, in the above-described embodiment, some specific examples in which the constituent materials of the thermally conductive member 1 of the present disclosure are mixed at a specific blending ratio are illustrated. However, the blending ratio of each constituent material can be optionally adjusted within the numerical range shown in the present disclosure.

### (4) Complement

Note that as is clear from the exemplary embodiments described above, the heat conduction member of the present disclosure may be further provided with configurations such as those given below.
(A) The first acrylic binder may contain at least an acrylic polymer and a plasticizer. Further, the first acrylic binder may contain from 15 to 45 parts by mass of the plasticizer in terms of a mass ratio relative to 100 parts by mass of the acrylic polymer.
(B) The first thermally conductive filler may contain at least silicon carbide having an average particle diameter from 60 to 100 µm, first spherical alumina having an average particle diameter from 70 to 100 µm, second spherical alumina having an average particle diameter from 1 to 30 µm, and first magnesium hydroxide having an average particle diameter from 0.5 to 2 µm. The second thermally conductive filler contains aluminum hydroxide having an average particle diameter from 5 to 50 µm as an essential component and may contain second magnesium hydroxide having an average particle diameter from 0.5 to 2 µm as an optional component. In the first thermally conductive filler, from 20 to 40 parts by mass of silicon carbide, from 20 to 50 parts by mass of the first spherical alumina, from 20 to 50 parts by mass of the second spherical alumina, and from 1 to 10 parts by mass of the first magnesium hydroxide may be blended in a mass ratio in 100 parts by mass of the first thermally conductive filler. From 90 to 100 parts by mass of aluminum hydroxide and from 0 to 10 parts by mass of the second magnesium hydroxide may be blended in the second thermally conductive filler at a mass ratio in 100 parts by mass of the second thermally conductive filler.
(C) The first layer may be configured to have an Asker C hardness from 0.1 to 22 and a thermal conductivity from 2 to 15 W/m·K.
(D) The plurality of layers may include a third layer stacked at a position in contact with the first layer on a side opposite to the second layer with the first layer interposed therebetween.
The third layer may be formed of a resin film having a thickness of 1 to 15 µm.

## Claims

1. A thermally conductive member, the thermally conductive member being a laminate provided with a plurality of layers including a first layer and a second layer stacked in contact with each other,
wherein the first layer is formed of a first thermally conductive composition containing at least a first acrylic binder, a first thermally conductive filler, and a dispersant,
the second layer is formed of a second thermally conductive composition containing at least a second acrylic binder and a second thermally conductive filler,
from 500 to 1200 parts by mass of the first thermally conductive filler and from 0.2 to 5 parts by mass of the dispersant are blended in the first thermally conductive composition in a mass ratio relative to 100 parts by mass of the first acrylic binder,
from 200 to 400 parts by mass of the second thermally conductive filler is blended in the second thermally conductive composition in a blending ratio relative to 100 parts by mass of the second acrylic binder, and
the dispersant contains at least one of a linear polyester having a weight-average molecular weight from 1000 to 2500 and having phosphoric acid at a terminal and a polyester-polyether copolymer having a weight-average molecular weight from 1000 to 2500 and having phosphoric acid at a terminal.

2. The thermally conductive member according to claim 1,
wherein the first acrylic binder contains at least an acrylic polymer and a plasticizer, and
the first acrylic binder contains from 15 to 45 parts by mass of the plasticizer in a mass ratio relative to 100 parts by mass of the acrylic polymer.

3. The thermally conductive member according to claim 1 or 2,
wherein the first thermally conductive filler contains at least silicon carbide having an average particle diameter from 60 to 100 µm, first spherical alumina having an average particle diameter from 70 to 100 µm, second spherical alumina having an average particle diameter from 1 to 30 µm, and first magnesium hydroxide having an average particle diameter from 0.5 to 2 µm,
the second thermally conductive filler contains aluminum hydroxide having an average particle diameter from 5 to 50 µm as an essential component, and contains second magnesium hydroxide having an average particle diameter from 0.5 to 2 µm as an optional component,
the first thermally conductive filler contains from 20 to 40 parts by mass of the silicon carbide, from 20 to 50 parts by mass of the first spherical alumina, from 20 to 50 parts by mass of the second spherical alumina, and from 1 to 10 parts by mass of the first magnesium hydroxide in a mass ratio in 100 parts by mass of the first thermally conductive filler, and
the second thermally conductive filler contains from 90 to 100 parts by mass of the aluminum hydroxide and 0 to 10 parts by mass of the second magnesium hydroxide in mass ratio in 100 parts by mass of the second thermally conductive filler; whereby the average particle diameter is measured according to the description.

4. The thermally conductive member according to any one of claims 1 to 3,
wherein the first layer has an Asker C hardness from 0.1 to 22 and a thermal conductivity from 2 to 15 W/m·K.

5. The thermally conductive member according to any one of claims 1 to 4,
wherein the plurality of layers include a third layer stacked at a position in contact with the first layer on a side opposite to the second layer with the first layer interposed therebetween, and
the third layer is formed of a resin film having a thickness from 1 to 15 µm.

## Patentansprüche

1. Ein wärmeleitfähiges Element, wobei das wärmeleitfähige Element ein Laminat ist, das mit einer Mehrzahl an Schichten ausgestattet ist, einschließlich einer ersten Schicht und einer zweiten Schicht, die in Kontakt miteinander gestapelt sind,
wobei die erste Schicht aus einer ersten wärmeleitfähigen Zusammensetzung gebildet ist, die mindestens ein erstes Acrylbindemittel, einen ersten wärmeleitfähigen Füllstoff und ein Dispergiermittel enthält,
die zweite Schicht aus einer zweiten wärmeleitfähigen Zusammensetzung gebildet ist, die mindestens ein zweites Acrylbindemittel und einen zweiten wärmeleitfähigen Füllstoff enthält,
500 bis 1200 Massenteile des ersten wärmeleitfähigen Füllstoffs und 0,2 bis 5 Massenteile des Dispergiermittels in die erste wärmeleitfähige Zusammensetzung in einem Massenverhältnis bezogen auf 100 Massenteile des ersten Acrylbindemittels, gemischt sind,
200 bis 400 Massenteile des zweiten wärmeleitfähigen Füllstoffs in die zweite wärmeleitfähige Zusammensetzung in einem Mischungsverhältnis bezogen auf 100 Massenteile des zweiten Acrylbindemittels, gemischt sind,
das Dispergiermittel mindestens eines ausgewählt aus einem linearen Polyester mit einem Gewichtsmittel des Molekulargewichts von 1000 bis 2500 und mit Phosphorsäure an einem Ende, und einem Polyester-Polyether-Copolymer mit einem Gewichtsmittel des Molekulargewichts von 1000 bis 2500 und mit Phosphorsäure an einem Ende enthält.

2. Das wärmeleitfähige Element gemäß Anspruch 1,
wobei das erste Acrylbindemittel mindestens ein Acrylpolymer und einen Weichmacher enthält, und
das erste Acrylbindemittel 15 bis 45 Massenteile des Weichmachers in einem Massenverhältnis bezogen auf 100 Massenteile des Acrylpolymers enthält.

3. Das wärmeleitfähige Element gemäß Anspruch 1 oder 2,
wobei der erste wärmeleitfähige Füllstoff mindestens Siliziumcarbid mit einem mittleren Teilchendurchmesser von 60 bis 100 µm, erstes kugelförmiges Aluminiumoxid mit einem mittleren Teilchendurchmesser von 70 bis 100 µm, zweites kugelförmiges Aluminiumoxid mit einem mittleren Teilchendurchmesser von 1 bis 30 µm und erstes Magnesiumhydroxid mit einem mittleren Teilchendurchmesser von 0,5 bis 2 µm enthält, der zweite wärmeleitfähige Füllstoff Aluminiumhydroxid mit einem mittleren Teilchendurchmesser von 5 bis 50 µm als eine wesentliche Komponente enthält, und zweites Magnesiumhydroxid mit einem mittleren Teilchendurchmesser von 0,5 bis 2 µm als eine optionale Komponente enthält,
der erste wärmeleitfähige Füllstoff 20 bis 40 Massenteile des Siliziumckarbids, 20 bis 50 Massenteile des ersten kugelförmigen Aluminiumoxids, 20 bis 50 Massenteile des zweiten kugelförmigen Aluminiumoxids und 1 bis 10 Massenteile des ersten Magnesiumhydroxids in einem Massenverhältnis bezogen auf 100 Massenteilen des ersten wärmeleitfähigen Füllstoffs enthält, und
der zweite wärmeleitfähige Füllstoff 90 bis 100 Massenteile des Aluminiumhydroxids und 0 bis 10 Massenteile des zweiten Magnesiumhydroxids in einem Massenverhältnis bezogen auf 100 Massenteilen des zweiten wärmeleitfähigen Füllstoffs enthält; wobei der mittlere Teilchendurchmesser gemäß der Beschreibung gemessen wird.

4. Das wärmeleitfähige Element gemäß einem der Ansprüche 1 bis 3,
wobei die erste Schicht eine Asker-C-Härte von 0,1 bis 22 und eine Wärmeleitfähigkeit von 2 bis 15 W/m•K aufweist.

5. Das wärmeleitfähige Element gemäß einem der Ansprüche 1 bis 4,
wobei die Mehrzahl an Schichten eine dritte Schicht umfasst, die an einer Position in Kontakt mit der ersten Schicht auf einer Seite, gegenüber der zweiten Schicht gestapelt ist, mit der ersten Schicht dazwischen angeordnet, und
die dritte Schicht aus einem Harzfilm mit einer Dicke von 1 bis 15 µm gebildet ist.

## Revendications

1. Organe thermoconducteur, l'organe thermoconducteur étant un stratifié muni d'une pluralité de couches incluant une première couche et une deuxième couche empilées l'une au contact de l'autre,
dans lequel la première couche est formée d'une première composition thermoconductrice contenant au moins un premier liant acrylique, une première charge thermoconductrice, et un dispersant,
la deuxième couche est formée d'une seconde composition thermoconductrice contenant au moins un second liant acrylique et une seconde charge thermoconductrice, de 500 à 1200 parties en masse de la première charge thermoconductrice et de 0,2 à 5 parties en masse du dispersant sont mélangées dans la première composition thermoconductrice dans un rapport massique par rapport à 100 parties en masse du premier liant acrylique,
de 200 à 400 parties en masse de la seconde charge thermoconductrice sont mélangées dans la seconde composition thermoconductrice dans un rapport de mélange par rapport à 100 parties en masse du second liant acrylique, et
le dispersant contient au moins l'un parmi un polyester linéaire présentant un poids moléculaire moyen en poids de 1000 à 2500 et présentant de l'acide phosphorique à une extrémité et un copolymère polyester-polyéther présentant un poids moléculaire moyen en poids de 1000 à 2500 et présentant de l'acide phosphorique à une extrémité.

2. Organe thermoconducteur selon la revendication 1,
dans lequel le premier liant acrylique contient au moins un polymère acrylique et un plastifiant, et
le premier liant acrylique contient de 15 à 45 parties en masse du plastifiant dans un rapport massique par rapport à 100 parties en masse du polymère acrylique.

3. Organe thermoconducteur selon la revendication 1 ou 2,
dans lequel la première charge thermoconductrice contient au moins du carbure de silicium présentant un diamètre moyen de particule de 60 à 100 µm, une première alumine sphérique présentant un diamètre moyen de particule de 70 à 100 µm, une seconde alumine sphérique présentant un diamètre moyen de particule de 1 à 30 µm, et un premier hydroxyde de magnésium présentant un diamètre moyen de particule de 0,5 à 2 µm,
la seconde charge thermoconductrice contient de l'hydroxyde d'aluminium présentant un diamètre moyen de particule de 5 à 50 µm en tant que composant essentiel, et contient un second hydroxyde de magnésium présentant un diamètre moyen de particule de 0,5 à 2 µm en tant que composant optionnel,
la première charge thermoconductrice contient de 20 à 40 parties en masse du carbure de silicium, de 20 à 50 parties en masse de la première alumine sphérique, de 20 à 50 parties en masse de la seconde alumine sphérique, et de 1 à 10 parties en masse du premier hydroxyde de magnésium dans un rapport massique par rapport à 100 parties en masse de la première charge thermoconductrice, et
la seconde charge thermoconductrice contient de 90 à 100 parties en masse de l'hydroxyde d'aluminium et de 0 à 10 parties en masse du second hydroxyde de magnésium en rapport massique par rapport à 100 parties en masse de la seconde charge thermoconductrice ; moyennant quoi le diamètre moyen de particule est mesuré selon la description.

4. Organe thermoconducteur selon l'une quelconque des revendications 1 à 3,
dans lequel la première couche présente une dureté Asker C de 0,1 à 22 et une conductivité thermique de 2 à 15 W/m·K.

5. Organe thermoconducteur selon l'une quelconque des revendications 1 à 4,
dans lequel la pluralité de couches inclut une troisième couche empilée à une position en contact avec la première couche sur un côté opposé à la deuxième couche avec la première couche interposée entre elles, et
la troisième couche est formée d'un film de résine présentant une épaisseur de 1 à 15 µm.
